# EUROPÄISCHE PATENTSCHRIFT

(11) **EP 0 985 235 B1**
(45) Veröffentlichungstag und Bekanntmachung des Hinweises auf die Patenterteilung: **08.10.2003**
(21) Anmeldenummer: 98934777.8
(22) Anmeldetag: 22.05.1998
(51) Int. Cl.: H01L 33/00

(54) **VERFAHREN ZUR HERSTELLUNG EINES LICHTEMITTIERENDEN BAUELEMENTES**
METHOD FOR PRODUCING A LIGHT-EMITTING COMPONENT
PROCEDE DE PRODUCTION D'UN ELEMENT CONSTITUTIF ELECTROLUMINESCENT

(30) Priorität: 27.05.1997 DE 19722156
(43) Veröffentlichungstag der Anmeldung: 15.03.2000
(73) Patentinhaber: Osram Opto Semiconductors GmbH, 93049 Regensburg (DE)
(72) Erfinder: NIRSCHL, Ernst, D-93173 Wenzenbach (DE); SCHÖNFELD, Olaf, D-93055 Regensburg (DE)
(74) Vertreter: Epping, Wilhelm, Dipl.-Ing.
(86) Internationale Anmeldenummer: DE9801412
(87) Internationale Veröffentlichungsnummer: WO98054764

(56) Entgegenhaltungen:
- EP-A- 0 420 691
- EP-A- 0 616 376
- PATENT ABSTRACTS OF JAPAN vol. 018, no. 008 (E-1486), 7. Januar 1994 -& JP 05 251739 A (TOSHIBA CORP), 28. September 1993

## Beschreibung

Die Erfindung bezieht sich auf ein Verfahren zur Herstellung eines lichtemittierenden Bauelementes, bei dem nach der Ausbildung einer wenigstens eine aktive Schicht enthaltenden Schichtenfolge auf der Vorderseite eines insbesondere aus Halbleitermaterial bestehenden Grundsubstrates das Grundsubstrat wenigstens teilweise entfernt und die Schichtenfolge nachfolgend mit einem Fremdsubstrat verbunden wird.

Lichtemittierende Halbleiterbauelemente werden auf der Grundlage von III-V-Halbleitersystemen hergestellt, bei denen auf einem Halbleitergrundsubstrat aus beispielsweise GaAs eine die aktive Schicht enthaltende lichtemittierende Schichtenfolge epitaktisch abgeschieden wird. Die aktive Schicht besteht beispielsweise aus InGaAlP mit unterschiedlichen Al-Konzentrationen. Für verschiedenste Anwendung ist es notwendig, die epitaktisch aufgetragene Schichtenfolge vom Grundsubstrat wieder zu entfernen (sogenanntes Epi-Lift-Off) und auf einem anderen Träger (Fremdsubstrat) unter Ausbildung guter elektrischer Kontakte zu fixieren. Abhängig von der gewünschten Anwendung und der zum Einsatz gelangenden Fertigungstechnologie sind zum Einen bei Einzelbauelementen und zum Anderen bei monolithisch integrierten Schaltkreisen unterschiedliche Problemstellungen zu lösen. Das vom Halbleiterchip emittierte sichtbare Licht wird zu einem bedeutenden Teil vom Grundsubstrat (beispielsweise GaAs) absorbiert, wodurch der externe Wirkungsgrad der Lichterzeugung minimal wird. Es wird somit ein für das emittierte Licht transparentes Substrat (beispielsweise GaP) bevorzugt, um höchste Lichtstärken von typischerweise 5 lm und mehr und Wirkungsgrade von typischerweise mehr als 10 % zu erreichen. Gleichzeitig wird eine gute elektrische Ankopplung zwischen der Epi-Schichtenfolge und dem Fremdsubstrat auch bei hohen Strömen gewünscht (bei minimaler Gesamtvorwärtsspannung des LED-Halbleiterchips), sowie eine hohe Ausbeute bei der Herstellung. Typische Anwendungen für solche Einzel-Halbleiterbauelemente sind Außenbeleuchtungen, Lampen und dergleichen im Kraftfahrzeug. Weiterhin ist die Realisierung optoelektronisch integrierter Schaltkreise durch eine Implementierung von kleinsten III-V-halbleitenden Epi-Schichten in integrierten Schaltkreisen auf Siliziumbasis möglich. Hierbei ist die elektrische Ankopplung der III-V-Halbleiterkomponente an die Silizium-Komponente entscheidend. Typische Anwendungsbeispiele hierfür sind LED-Displays, optische Informationsverarbeitungssysteme und dergleichen.

Die Fertigung, Fixierung und elektrische Kontaktierung einer Epitaxieschicht auf einem Fremdsubstrat wurde bislang im Wesentlichen durch zwei Verfahren durchgeführt: Heteroepitaxie und Fusion von Epi-Schichten auf Fremdsubstraten.

Bei der Heteroepitaxie beispielsweise von InGaAlP auf GaP kommt es aufgrund großer Gitterfehlanpassungen der verwendeten Materialien zwangsweise zu hohen Versetzungsdichten. Diese lassen sich zwar reduzieren, indem entweder vermittels SiO₂-Masken die Epitaxieflächen reduziert werden, so dass sich Verspannungen leichter abbauen können, oder durch herkömmliche Methoden wie beispielsweise thermisch zyklisches Kristallwachstum, Einbringung von Interfaces und dergleichen. Gleichwohl führt die hohe Dichte an Versetzungen zu einer Verstärkung nichtstrahlender Rekombinationsvorgänge und damit zu einer reduzierten Lichtemission, sowie zu undefinierten additiven Spannungsabfällen am Chip, was für die elektrische Ankopplung ungünstig ist.

Bei der Fusion von Epi-Schichten auf Fremdsubstraten wird das absorbierende GaAs-Grundsubstrat durch selektives Unterätzen nass-chemisch von der Epi-Schichtenfolge entfernt, wobei vorab eine AlN-Schicht eingebracht wurde. Die verbleibende Epi-Schichtenfolge wird auf ein transparentes GaP-Fremdsubstrat unter hohem Druck und hoher Temperatur aufgebracht. Über die Ausbildung von van der Waals-Bindungen haftet die Epi-Schichtenfolge auf dem transparenten Fremdsubstrat.

Alternativ könnte die abgelöste Epi-Schichtenfolge auf der (früheren) Grundsubstratseite mit einem Metallfilm der Dicke von wenigen Nanometern bedampft werden. Die Epi-Schichtenfolge würde daran anschließend auf ein transparentes oder absorbierendes Fremdsubstrat gebracht, welches gegebenenfalls ebenfalls mit einem dünnen Metallfilm versehen ist. Anschließend erfolgte unter Tempern ein Einlegieren am Metallübergang. Über die Legierung hafte die Epi-Schichtenfolge am Fremdsubstrat.

Nachteilig bei allen dargestellten Herstellungsverfahren (letzteres ist nicht dem Stand der Technik zuzurechnen) sind undefinierte Übergänge der beiden zu verbindenden Körper, die im Wesentlichen aufgrund einer inhomogenen Abätzung des absorbierenden Substrates über einige hundert Mikrometer verursacht sind. Die inhomogenen van der Waals-Bindungen zwischen Epi-Schichtenfolge und Fremdsubstrat und die damit einhergehende Bildung von Oxiden können zu ungünstig hohen Spannungsabfällen am Halbleiterchip führen und die Ausbeute erheblich verringern. So wurden bei handelsüblichen LED-Halbleiterbauelementen für Hochstromanwendungen, bei denen die InGaAlP-Schichtenfolge auf einem GaP-Fremdsubstrat durch Fusion verbunden wurde, Vorwärtsspannungen von 2,4 mV und darüber bei 70 mA gemessen, was ihre Anwendung stark einschränkt.

Aus der EP 0 616 376 A1 ist ein Verfahren zum Waferbonden von LED-Schichten bekannt geworden, wobei die LED-Schichten auf einem Wachstumssubstrat hergestellt werden, das hiernach entfernt wird. Die LED-Schichten werden vermittels einer herkömmlichen Waferbondtechnik flächig mit einem zweiten Substrat von geeigneten optischen Eigenschaften verbunden, um einen niedrigen Kontaktwiderstand, oder gewünschte optische Grenzflächeneigenschaften mit dem zweiten Substrat zu erzielen.

Aus der JP-A 5 251 739 ist eine lichtemittierende Halbleitervorrichtung bekannt geworden, die zur Erzeugung einer Mischfarbe die elektrische Kontaktierung einer roten GaAsP-LED und einer grünen GaP-LED vorsieht, wobei zur elektrischen Kontaktierung der beiden LED miteinander die Verwendung einer eutektischen Legierung vorgesehen ist.

Der Erfindung liegt daher die Aufgabe zugrunde, ein Verfahren zur Herstellung eines vorzugsweise in der Optoelektronik und der Automobilelektronik zum Einsatz gelangenden lichtemittierenden Bauelementes zur Verfügung zu stellen, welches verbesserte elektrische Übergänge zwischen der Epi-Schichtenfolge und dem Fremdsubstrat insbesondere auch bei hohen elektrischen Strömen sowie eine Steigerung der Ausbeute hergestelter LED-Halbleiterchips durch definierte elektrische Übergänge ermöglicht.

Diese Aufgabe wird durch ein Verfahren nach Anspruch 1 oder 8 gelöst.

Die Erfindung besteht darin, dass auf die der Vorderseite des entfernten Grundsubstrates zugewandten Rückseite der Schichtenfolge eine erste metallische Kontaktschicht und auf die Vorderseite des Fremdsubstrates eine zweite metallische Kontaktschicht aufgebracht wird, und die dergestalt beschichtete Rückseite der Schichtenfolge mit der sonach beschichteten Vorderseite des Fremdsubstrates bevorzugt durch eutektisches Bonden miteinander verbunden werden.

Das Grundsubstrat wird bevorzugt durch eine nass-chemische Ätzung in einem für das Material des Grundsubstrats selektiven Ätzmittel entfernt, wobei bei einer besonders vorteilhaften Ausgestaltung des Verfahrens der nass-chemischen Ätzung des Grundsubstrates eine mechanische Dünnung des Grundsubstrates vorausgeht. Dadurch kann eine sehr homogene Ablösung des Grundsubstrats von der die aktive Schicht enthaltenden Schichtenfolge erreicht werden.

Das erfindungsgemäße Verfahren besitzt gegenüber den bisher verwendeten Verfahren vor allem den Vorteil der Fertigung definierter und elektrisch leitender Übergänge zwischen der epitaktisch aufgewachsenen Schichtenfolge und dem Fremdsubstrat, und zwar in Folge einer Kombinationswirkung durch zum Einen einer definierten Substratätzung des nur eine minimale Dicke aufweisenden Grundsubstrates und zum Anderen eutektisches Bonden der freitragenden Schichtenfolge auf das vorzugsweise transparente Fremdsubstrat. Im Sinne einer solchen definierten Substratätzung besonders vorteilhaft ist daher, wenn das Grundsubstrat eine nur geringe Gesamtdicke von maximal etwa 100 µm besitzt. Bei dickeren Grundsubstraten ist beim erfindungsgemäßen Verfahren vorgesehen, dass der nass-chemischen Ätzung des Grundsubstrates eine mechanische Dünnung des Grundsubstrates auf eine vorteilhafte Gesamtdicke von typischerweise 100 µm vorausgeht. Damit kann auch bei Waferdurchmessern von zwei Zoll und größer eine homogene Auflösung des Grundsubstrates durch Ätzung erfolgen.

Zum eutektischen Bonden der beiden ersten und zweiten metallischen Kontaktschichten wird vorteilhafterweise eine goldhaltige Lotschicht verwendet, die strukturiert entweder auf der ersten oder zweiten Kontaktschicht, oder auch auf beiden aufgetragen wird und beim Zusammenfügen der beiden Kontaktschichten vorzugsweise durch Laserlöten aufgeschmolzen wird und die beiden Teile bei der nachfolgenden Abkühlung am Übergang zusammenlötet. Vorteilhafterweise erfolgt die Haftung des eutektischen Lotes nur an den hierfür vorgesehenen Stellen der strukturierten Metallisierungen. Dadurch kann ein definierter metallischer Übergang zwischen den beiden Teilkomponenten erzeugt werden, wodurch sich günstige Bauelementeeigenschaften auch bei hohen elektrischen Strömen und gleichzeitig hohe Ausbeuten bei der Fertigung des Bauelementes ergeben.

Vorteilhafte Weiterbildungen der Erfindung ergeben sich aus den Unteransprüchen.

Nachfolgend wird die Erfindung anhand eines in.der Zeichnung dargestellten Ausführungsbeispieles weiter erläutert. Im Einzelnen zeigen die schematischen Darstellungen in:
- Figur 1: einen schematischen Querschnitt durch eine auf einem Grundsubstrat epitaktisch abgeschiedene Schichtenfolge;
- Figur 2: einen schematischen Querschnitt nach Ätzung eines vergleichsweise dicken Grundsubstrates; und
- Figur 3: eine schematische Darstellung eines nach der Erfindung hergestellten lichtemittierenden Bauelementes mit der auf dem Fremdsubstrat eutektisch gebondeten Schichtenfolge.

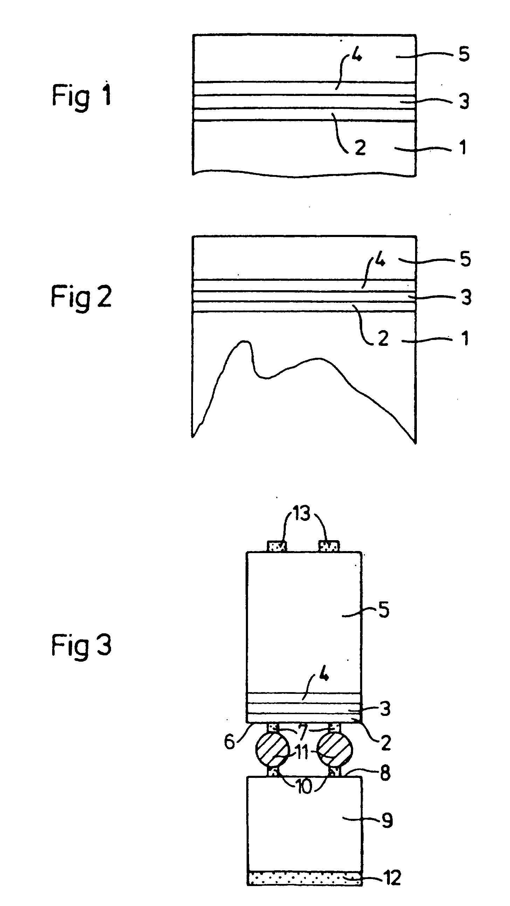

Das in den Figuren dargestellte Ausführungsbeispiel eines nach dem erfindungsgemäßen Verfahren hergestellten lichtemittierenden Bauelementes umfasst ein Halbleitergrundsubstrat 1 aus GaAs, auf welchem eine epitaktisch abgeschiedene Schichtenfolge aufgebracht ist, die ausgehend vom Halbleitersubstrat 1 eine erste Mantelschicht 2, eine aktive Schicht 3 und eine zweite Mantelschicht 4 aufweist. Die aktive Schicht 3 nachdem Ausführungsbeispiel gemäß Figur 1 stellt eine InGaAlP-Doppel-Heterostruktur mit einer Wellenlänge der emittierten Strahlung von typischerweise maximal 800 nm dar; alternativ kann die aktive Schicht auch durch einen Homo-pn-Übergang ausgebildet sein. Oberhalb der zweiten Mantelschicht 4 ist eine Auskopplungsschicht 5 aus GaP mit einer Stärke von typischerweise 10 µm bis etwa 50 µm abgeschieden, die der Verbesserung des optischen Auskopplungswirkungsgrades des von der Lumineszenzdiode abgestrahlten Lichtes dient. Anordnung und Funktion der aus den einzelnen Schichten 2, 3, 4, 5 bestehenden Schichtenfolge bei insbesondere als Lichtquelle, Sendeelemente in der optischen Nachrichtentechnik verwendeten Lumineszenzdioden bzw. lichtemittierenden Dioden sind dem Fachmann geläufig und brauchen hier nicht näher erläutert zu werden. In Abhängigkeit der gewünschten Wellenlänge des emittierten Lichtes werden unterschiedliche Halbleitersysteme verwendet, deren jeweils zugrunde liegende Halbleitermaterialien auch unterschiedliche Herstellverfahren mit jeweils eigenständigen technologischen Problemstellungen nach sich ziehen. Im sichtbaren Spektralbereich mit Wellenlängen von etwa 400 bis 800 nm wird ein AlGaInP-Legierungssystem verwendet, welches auch dem dargestellten Ausführungsbeispiel zugrunde liegt, bei dem durch Einstellung des Aluminiumgehaltes die gewünschte Wellenlänge aus einem relativ breiten Farbbereich festgelegt werden kann. Im Prinzip ist das erfindungsgemäße Verfahren jedoch auch zur Herstellung von Lumineszenzdioden mit größeren Wellenlängen im Infrarotbereich anwendbar, die in der Regel auf einem AlGaAs-System basieren, bei dem durch Einstellung des Aluminiumgehaltes im typischen Bereich von etwa 10 % bis 30 % Wellenlängen des emittierten Lichtes von oberhalb etwa 800 nm erreicht werden können.

Das Grundsubstrat 1 aus GaAs kann zunächst eine Gesamtdicke von typischerweise einigen mehreren hundert Mikrometern besitzen. Als vorhergehender Schritt ist zur Anwendung des erfindungsgemäßen Verfahren in diesem Fall eine mechanische Dünnung des Grundsubstrates 1 vorzugsweise durch Schleifen vorgesehen, aufgrund welcher die Gesamtdicke des Grundsubstrates 1 auf etwa 100 µm eingestellt wird. Der Zustand nach dem Schleifen ist in Figur 1 dargestellt. Daran anschließend wird der Halbleiterwafer in ein für das Material des Grundsubstrates 1 selektives Ätzmittel getaucht. Im Falle von GaAs kann als Ätzmittel beispielsweise eine Lösung mit H₂O:NH₃:H₂O₂ im Verhältnis von 4:2:1 verwendet werden. Nach etwa 45 min. ist das Grundsubstrat 1 vollständig aufgelöst, während die aus den Schichten 2, 3, 4, 5 bestehende Schichtenfolge nicht angegriffen ist. Die Auflösung des GaAs-Grundsubstrates 1 erfolgt hierbei äußerst homogen, da seine Dicke minimal ist. Es ist ohne weiteres möglich, abgelöste Schichtenfolgen mit Waferdurchmessern von zwei Zoll und mehr zu erhalten.

Figur 2 zeigt den Fall eines mehrere hundert µm dicken GaAs-Grundsubstrates 1, welches ohne vorhergehende mechanische Dünnung nass-chemisch geätzt wurde. Man erkennt hier einen unregelmäßigen Ätzangriff, welcher letztlich zu einem nicht mehr homogenen Übergang zwischen der Schichtenfolge und dem nachfolgend zu verbindenden transparenten Fremdsubstrat führt. Im Sinne des erfindungsgemäßen Verfahrens ist es daher günstiger, wenn bei dickeren Grundsubstraten 1 zunächst ein mechanischer Schleifvorgang durchgeführt wird.

Figur 3 zeigt schematisch die Fixierung und elektrische Kontaktierung der nass-chemisch abgelösten Epitaxieschichtenfolge auf einem Fremdsubstratträger. Hierzu wird auf der Rückseite 6 der abgelösten Schichtenfolge (n-Seite) ein n-Kontakt 7 strukturiert aufgebracht, der mit einer dünnen Goldschicht belegt ist. Auf die Vorderseite 8 des transparenten Fremdsubstrates 9 wird gleichfalls ein strukturierter n-Kontakt 10 (im Falle eines n-dotierten GaP-Fremdsubstrates 9) oder auch eine andere Metallisierung (beispielsweise für Fremdsubstrate aus Glas oder Silizium) aufgebracht, dessen Oberfläche mit einer dünnen AuSn-Schicht als eutektisches Lot belegt ist. Das mit der metallischen Kontaktschicht 10 versehene transparente Fremdsubstrat 9 und die mit der metallischen Kontaktschicht 7 versehene Schichtenfolge werden aufeinandergelegt und mit einer geeigneten Wärmequelle getempert. Die AuSn-Beschichtung auf der einen Kontaktschicht 10 schmilzt auf (schematisch durch das Bezugszeichen 11 dargestellt) und lötet bei Abkühlung die beiden Teilkomponenten am Übergang zusammen, so dass sich eine wie in Figur 3 schematisch dargestellte elektrische und mechanische Verbindung zwischen Epi-Schichtenfolge 2, 3, 4, 5 - Rückseitenkontakt 7 - AuSn-Vorderseitenkontakt 10 - transparentes Fremdsubstrat 9 ergibt. Dabei erfolgt die Haftung des eutektischen Lotes 11 nur an den Metallisierungen 7 und 10. Es entsteht somit ein definierter metallischer Übergang zwischen den beiden Chipkomponenten, der günstige Bauelementeeigenschaften auch bei hohen elektrischen Strömen ermöglicht, und zwar mit vergleichsweise hohen Fertigungsausbeuten. Der Vollständigkeit halber bezeichnen die Bezugsziffern 12 eine metallische n-Rückseitenkontaktierung auf dem Fremdsubstrat 9 und das Bezugszeichen 13 einen strukturierten p-Kontakt auf der Auskopplungsschicht 5.

## Patentansprüche

1. Verfahren zur Herstellung eines lichtemittierenden Bauelementes, bei dem nach der Ausbildung einer wenigstens eine aktive Schicht (3) enthaltenden Schichtenfolge (2, 3, 4, 5) auf der Vorderseite eines Grundsubstrates (1) das Grundsubstrat (1) wenigstens teilweise entfernt und die Schichtenfolge (2, 3, 4, 5) nachfolgend mit einem Fremdsubstrat (9) verbunden wird, bei dem beschichtete Rückseite (6) der Schichtenfolge (2, 3, 4, 5) mit der beschichteten Vorderseite (8) des Fremdsubstrates (9) unter Wärmeeinwirkung miteinander verbunden werden, wobei
auf die der Vorderseite des entfernten Grundsubstrates (1) zugewandten Rückseite (6) der Schichtenfolge (2, 3, 4, 5) eine erste metallische Kontaktschicht (7) und auf die Vorderseite (8) des Fremdsubstrates (9) eine zweite metallische Kontaktschicht(10) strukturiert wird, **dadurch gekennzeichnet dass** die erste und die zweite metallische Kontaktschicht (7, 10) durch eutektisches Bonden vermittels mindestens einer zusätzlichen Lotschicht zwischen den beiden strukturierten Kontaktschichten (7, 10) miteinander verbunden werden, und
dass die Verbindung der beschichteten Rückseite der Schichtenfolge und der beschichteten Vorderseite der Schichtenfolge des Fremdsubstrats ausschließlich über die strukturierten metallischen Kontaktschichten erfolgt.

2. Verfahren nach Anspruch 1,
**dadurch gekennzeichnet,**
**dass** die zum eutektischen Bonden der ersten und zweiten metallischen Kontaktschichten (7, 10) verwendete Lotschicht goldhaltig ist.

3. Verfahren nach Anspruch 1 oder 2,
**dadurch gekennzeichnet,**
**dass** das Fremdsubstrat (9) aus einem transparenten Material besteht.

4. Verfahren nach einem der Ansprüche 1 bis 3,
**gekennzeichnet**
**durch** eine auf einem GaAs-Grundsubstrat (1) epitaktisch abgeschiedene Schichtenfolge (2, 3, 4, 5) mit einer InGaAlP und/oder GaAs und/oder AlGaAs enthaltenden aktiven Schicht (3).

5. Verfahren nach einem der Ansprüche 1 bis 4,
**dadurch gekennzeichnet,**
**dass** die epitaktisch abgeschiedene Schichtenfolge (2, 3, 4, 5) ausgehend vom Grundsubstrat (1) eine erste Mantelschicht (2), eine aktive Schicht (3), eine zweite Mantelschicht (4), und eine Auskopplungsschicht (5) aufweist.

6. Verfahren nach einem der Ansprüche 1 bis 5,
**dadurch gekennzeichnet,**
**dass** die Herstellung einer Vielzahl von lichtemittierenden Bauelementen im Waferverbund erfolgt, wobei der Wafer einen Durchmesser von zwei Zoll oder mehr besitzt.

7. Verfahren nach einem der Ansprüche 1 bis 6,
**dadurch gekennzeichnet,**
**dass** auf der dem Grundsubstrat (1) bzw. dem Fremdsubstrat (9) abgewandten Vorderseite der Schichtenfolge (2, 3, 4, 5) eine Auskopplungsschicht (5) gefertigt wird, und auf der Auskopplungsschicht (5) eine insbesondere strukturiert abgeschiedene metallische Elektrodenschicht (13) vorgesehen wird.

8. Verfahren nach einem der Ansprüche 1 bis 7,
**dadurch gekennzeichnet,**
**dass** das Grundsubstrat (1) durch eine nass-chemische Ätzung mit einem für das Material des Grundsubstrats selektiven Ätzmittel entfernt wird.

9. Verfahren nach Anspruch 8,
**dadurch gekennzeichnet,**
**dass** der nass-chemischen Ätzung des Grundsubstrates (1) eine mechanische Dünnung des Grundsubstrates (1) vorausgeht.

## Claims

1. Method for producing a light-emitting component, in which, after the formation of a layer sequence (2, 3, 4, 5) containing at least one active layer (3) on the front side of a base substrate (1), the base substrate (1) is at least partially removed and the layer sequence (2, 3, 4, 5) is subsequently joined to a foreign substrate (9), and in which the coated rear side (6) of the layer sequence (2, 3, 4, 5) is joined together with the coated front side (8) of the foreign substrate (9) under the action of heat, a first metallic contact layer (7) being patterned on the rear side (6) of the layer sequence (2, 3, 4, 5), said rear side facing the front side of the removed base substrate (1), and a second metallic contact layer (10) being patterned on the front side (8) of the foreign substrate (9), **characterized in that** the first and second metallic contact layers (7, 10) are joined together by eutectic bonding by means of at least one additional solder layer between the two patterned contact layers (7, 10), and
**in that** the coated rear side of the layer sequence and the coated front side of the layer sequence of the foreign substrate are joined exclusively via the patterned metallic contact layers.

2. Method according to Claim 1,
**characterized**
**in that** the solder layer used for eutectically bonding the first and second metallic contact layers (7, 10) contains gold.

3. Method according to Claim 1 or 2,
**characterized**
**in that** the foreign substrate (9) is composed of a transparent material.

4. Method according to one of Claims 1 to 3,
**characterized**
**by** a layer sequence (2, 3, 4, 5) epitaxially deposited on a GaAs base substrate (1) and having an active layer (3) containing InGaAlP and/or GaAs and/or AlGaAs.

5. Method according to one of Claims 1 to 4,
**characterized**
**in that** the epitaxially deposited layer sequence (2, 3, 4, 5) has, proceeding from the base substrate (1), a first cladding layer (2), an active layer (3), a second cladding layer (4) and a coupling-out layer (5).

6. Method according to one of Claims 1 to 5,
**characterized**
**in that** a multiplicity of light-emitting components are produced from a wafer as a whole, the wafer having a diameter of two inches or more.

7. Method according to one of Claims 1 to 6,
**characterized**
**in that** a coupling-out layer (5) is fabricated on the front side of the layer sequence (2, 3, 4, 5), said front side being remote from the base substrate (1) and/or the foreign substrate (9), and a metallic electrode layer (13) deposited in particular in a patterned manner is provided on the coupling-out layer (5).

8. Method according to one of Claims 1 to 7,
**characterized**
**in that** the base substrate (1) is removed by wet-chemical etching using an etchant which is selective for the material of the base substrate.

9. Method according to Claim 8,
**characterized**
**in that** the wet-chemical etching of the base substrate (1) is preceded by mechanical thinning of the base substrate (1).

## Revendications

1. Procédé de production d'un composant émettant de la lumière, dans lequel, après avoir constitué une succession (2, 3, 4, 5) de couches comportant au moins une couche (3) active sur la face avant d'un substrat (1) de base, on élimine au moins en partie le substrat (1) de base et on relie ensuite la succession (2, 3, 4, 5) de couches à un substrat (9) étranger, dans lequel des faces (6) arrières revêtues de la succession (2, 3, 4, 5) de couches sont reliées entre elles sous l'action de la chaleur par la face (8) avant revêtue du substrat (9) étranger, une première couche (7) métallique de contact étant structurée sur la face (6) arrière, tournée vers la face avant du substrat (1) de base éliminée, de la succession (2, 3, 4, 5) de couches et une deuxième couche (10) métallique de contact étant structurée sur la face (8) avant du substrat (9) étranger,
**caractérisé**
**en ce que** la première et la deuxième couches (7, 10) métalliques de contact sont reliées entre elles par liaison eutectique au moyen d'au moins une couche supplémentaire de brasure entre les deux couches (7, 10) structurées de contact et
**en ce que** la liaison entre la face arrière revêtue de la succession de couches et la face avant revêtue de la succession de couches du substrat étranger s'effectue exclusivement par les couches métalliques de contact structurées.

2. Procédé suivant la revendication 1,
**caractérisé**
**en ce que** la couche de brasure utilisée pour la liaison eutectique des première et deuxième couches (7, 10) métalliques de contact contient de l'or.

3. Procédé suivant la revendication 1 ou 2,
**caractérisé**
**en ce que** le substrat (9) étranger est en une matière transparente.

4. Procédé suivant l'une des revendications 1 à 3,
**caractérisé**
**par** une succession (2, 3, 4, 5) de couches déposées par épitaxie sur un substrat (1) de base en GaAs et ayant une couche (3) active contenant InGaAlP et/ou GaAs et/ou AlGaAs.

5. Procédé suivant l'une des revendications 1 à 4,
**caractérisé**
**en ce que** la succession (2, 3, 4, 5) de couches déposées par épitaxie a, en partant du substrat (1) de base, une première couche (2) de gaine, une couche (3) active, une deuxième couche (4) de gaine et une couche (5) de sortie.

6. Procédé suivant l'une des revendications 1 à 5,
**caractérisé**
**en ce que** l'on effectue la production d'une pluralité de composants émettant de la lumière en liaison par la tranche, la tranche ayant un diamètre de deux pouces ou plus.

7. Procédé suivant l'une des revendications 1 à 6,
**caractérisé**
**en ce que** l'on ménage sur la face avant, tournée vers le substrat (1) de base ou le substrat (9) étranger, de la succession (2, 3, 4, 5) de couches une couche (5) de sortie et l'on prévoit sur la couche (5) de sortie une couche (13) métallique d'électrode déposée notamment de manière structurée.

8. Procédé suivant l'une des revendications 1 à 7,
**caractérisé**
**en ce que** l'on élimine le substrat (1) de base par une attaque chimique en voie humide à l'aide d'un agent d'attaque sélectif pour la matière du substrat de base.

9. Procédé suivant la revendication 8,
**caractérisé**
**en ce que** l'on fait précéder l'attaque chimique en voie humide du substrat (1) de base d'un amincissement mécanique du substrat (1) de base.
